# EUROPÄISCHE PATENTSCHRIFT

(11) **EP 2 566 997 B1**
(45) Veröffentlichungstag und Bekanntmachung des Hinweises auf die Patenterteilung: **20.02.2019**
(21) Anmeldenummer: 11716600.9
(22) Anmeldetag: 03.05.2011
(51) Int. Cl.: C23C 14/22, C23C 14/35, C23C 14/32, C23C 14/08, C23C 28/04, C23C 30/00

(54) **PVD-HYBRIDVERFAHREN ZUM ABSCHEIDEN VON MISCHKRISTALLSCHICHTEN**
PVD HYBRID METHOD FOR DEPOSITING MIXED CRYSTAL LAYERS
PROCÉDÉ DE PVD HYBRIDE POUR DÉPOSER DES COUCHES DE CRISTAL MIXTE

(30) Priorität: 04.05.2010 DE 102010028558
(43) Veröffentlichungstag der Anmeldung: 13.03.2013
(73) Patentinhaber: Walter AG, 72072 Tübingen (DE)
(72) Erfinder: ENGELHART, Wolfgang, 72555 Metzingen (DE); SCHIER, Veit, 70771 Leinfelden-Echterdingen (DE)
(74) Vertreter: WSL Patentanwälte Partnerschaft mbB
(86) Internationale Anmeldenummer: PCT/EP2011/057064
(87) Internationale Veröffentlichungsnummer: WO 2011/138331

(56) Entgegenhaltungen:
- EP-A2- 2 037 000
- RAMM ET AL: "Pulse enhanced electron emission (P3e(TM)) arc evaporation and the synthesis of wear resistant Al-Cr-O coatings in corundum structure", SURFACE AND COATINGS TECHNOLOGY, ELSEVIER, AMSTERDAM, NL, Bd. 202, Nr. 4-7, 13. November 2007 (2007-11-13), Seiten 876-883, XP022342030, ISSN: 0257-8972, DOI: 10.1016/J.SURFCOAT.2007.05.044
- CHANG SEONG YOON ET AL: "Syntheses and Properties of Cr-Al-Mo-N Coatings Fabricated by Using a Hybrid Coating System", JOURNAL OF THE KOREAN PHYSICAL SOCIETY, Bd. 54, Nr. 3, 14. März 2009 (2009-03-14), Seiten 1237-1241, XP55040469, ISSN: 0374-4884, DOI: 10.3938/jkps.54.1237
- DIECHLE D ET AL: "Combinatorial approach to the growth of alpha-(Al1-x,Crx)2O3 solid solution strengthened thin films by reactive r.f. magnetron sputtering", SURFACE AND COATINGS TECHNOLOGY, ELSEVIER, AMSTERDAM, NL, Bd. 204, Nr. 20, 15. Juli 2010 (2010-07-15), Seiten 3258-3264, XP027061112, ISSN: 0257-8972 [gefunden am 2010-03-21]
- Mirjam Witthaut ET AL: "Preparation of Cr 2 O 3 -Al 2 O 3 Solid Solutions by Reactive Magnetron Sputtering", MIKROCHIMICA ACTA., vol. 133, no. 1-4, 19 June 2000 (2000-06-19), pages 191-196, XP55477143, AT ISSN: 0026-3672, DOI: 10.1007/s006040070092

## Beschreibung

Die vorliegende Erfindung betrifft ein Verfahren zum Abscheiden von Mischkristallschichten mit wenigstens zwei Metallen (M1, M2) auf einem Substrat mittels PVD-Verfahren.

### Stand der Technik

Schneidwerkzeuge, die beispielsweise zur spanabhebenden Metallbearbeitung eingesetzt werden, bestehen in der Regel aus einem Grundkörper (Substrat) aus Hartmetall, Cermet, Stahl oder Schnellarbeitsstahl mit einer verschleißbeständigen ein- oder mehrlagigen Beschichtung aus metallischen Hartstoffschichten, Oxidschichten und dergleichen. Zum Aufbringen solcher Beschichtungen werden CVD-Verfahren (Chemische Gasphasenabscheidung) und/oder PVD-Verfahren (Physikalische Gasphasenabscheidung) angewendet. Bei den PVD-Verfahren unterscheidet man zwischen verschiedenen Varianten, beispielsweise Kathodenzerstäubung (Sputter-Abscheidung), Lichtbogenverdampfen (Arc-PVD), lonenplattierung, Elektronenstrahlverdampfung und Laserablation. Kathodenzerstäubung, wie Magnetronsputtern, reaktives Magnetronsputtern oder High Power Impulse Magnetronsputtern (HIPIMS), und das Lichtbogenverdampfen zählen zu den am häufigsten für die Beschichtung von Schneidwerkzeugen angewendeten PVD-Verfahren.

Beim Sputtern (Kathodenzerstäubung) werden aus dem Target durch Beschuss mit energiereichen Ionen Atome oder Moleküle herausgelöst und in die Gasphase überführt, wo sie dann entweder direkt oder nach Umsetzung mit einem Reaktionsgas auf dem Substrat abgeschieden werden. Beim Lichtbogenverdampfen brennt zwischen der Kammer und dem Target ein Lichtbogen, der das Targetmaterial schmilzt und verdampft. Dabei wird ein großer Teil des verdampften Materials ionisiert und zu dem mit einem negativen Potential belegten Substrat hin beschleunigt und auf der Substratoberfläche abgeschieden.

Sowohl durch Magnetronsputtern als auch Lichtbogenverdampfen können Metalloxidschichten auf einem Substrat abgeschieden werden. Durch Lichtbogenverdampfen werden üblicherweise höhere Abscheidungsgeschwindigkeiten erzielt. Die Varianten des einfachen und des dualen Magnetronsputtern haben den Nachteil, dass viele Oxide in der besonders stabilen und daher erwünschten Alpha-Phase nicht oder höchstens teilweise erzielt werden können, wie beispielsweise beim Aluminiumoxid oder beim Aluminium-Chrom-Mischoxid. Beim Lichtbogenverdampfen kann man einen sehr hohen Anteil an Alpha-Phase der Metalloxide erreichen. Ein Nachteil des Lichtbogenverdampfens ist allerdings, dass verfahrensbedingt sehr viele Makropartikel (Droplets) mit abgeschieden werden, deren Vermeidung äußerst aufwendig ist. Die nach den vorgenannten Verfahren abgeschiedenen Schichten haben aufgrund der Abscheidung als instabile Phasen oder Mischphasen und/oder der Abscheidung mit sehr vielen Makropartikeln häufig nicht die ausreichend hohe Härte und niedrige Wärmeleitfähigkeit für bestimmte Anwendungen, bei denen diese Eigenschaften erforderlich sind.

Die DE 44 05 477 und Die DE 43 31 890 beschreiben die Herstellung von Nitridschichten, bei dem die Abscheidung eines Grundmaterials mittels unbalanziertem Magnetronsputtern (einfaches Magnetronsputtern) gestartet wird. Im späteren Verlauf der Schichtabscheidung wird dann kathodische Bogenentladung zugeschaltet, um zusätzliche Metalle (Einbaumaterial) in die Schicht des abgeschiedenen Grundmaterials einzubauen. Es ergibt sich eine mehrlagige Beschichtung, wobei davon auszugehen ist, dass aufgrund der niedrigen Plasmaenergien beim unbalanzierten Magnetronsputtern mehrphasige Schichten entstehen.

Die US 2005/0284747 beschreibt die Herstellung siliziumhaltiger Mehrlagenbeschichtungen mittels Magnetronsputtern und Lichtbogenverdampfen, wobei die Beschichtungen ein mehrphasiges Gefüge mit Alpha-Siliziumnitrid und Beta-Siliziumnitrid aufweisen. Es wird kein Mischkristallgefüge erzielt. Aluminiuim und Legierungen davon werden im Lichtbogen abgeschieden, was zur Bildung von Makropartikeln (Droplets) führt.

Die EP 0 306 612 beschreibt die Herstellung von Beschichtungen auf Substraten mittels Kathodenzerstäubung und Bogenverdampfung, um gegenüber reiner Kathodenzerstäubung kompaktere, dichtere Schichten zu erhalten. Die abgeschiedenen Schichten weisen mit Nachteil in der Regel Mischphasen und viele Makropartikeln auf.

Ramm et al in Surface & Coatings Technology , 204(20), 2010, 3258-3264, offenbaren ein Verfahren zum Abscheiden von Al-Cr-O Schichten mittels gepulstem Lichtbogenverdampfen.

Yoon et al., J. Korean Phys. Soc. (2009), 53, 1237-1241 beschreibt die Herstellung quaternärer Cr-Al-Mo-N-Beschichtungen auf Stahl- oder Si-Substraten mit einem Hybridverfahren, das Lichtbogenverdampfen mit einem Cr-Target und DC Magnetronsputtern mit Al- und Mo-Targets unter einer N2/Ar-Atmosphäre anwendet. Allerdings werden mit diesem Verfahren keine einphasigen Mischkristalle erhalten.

Die EP 2 037 000 beschreibt ein Verfahren und eine Vorrichtung zum Abscheiden von Beschichtungen mittels Lichtbogenverdampfen und dualem Magnetronsputtern nacheinander oder gleichzeitig. Die Verwendung eines solchen Verfahrens zur Abscheidung von Mischkristallen, insbesondere von einphasigen Mischkristallen, wird allerdings nicht beschrieben.

### Aufgabe

Die Aufgabe der vorliegenden Erfindung bestand daher darin, ein Verfahren zum Abscheiden von Mischkristallschichten mit wenigstens zwei verschiedenen Metallen auf einem Substrat mittels PVD-Verfahren bereitzustellen, mit dem man Mischkristallschichten erhält, die möglichst frei sind von Makropartikeln (Droplets) und die einen möglichst hohen Anteil einer gewünschten kristallinen Phase aufweisen, insbesondere einphasigen Mischkristallschichten, und die hochkristallin sind.

### Beschreibung der Erfindung

Gelöst wird diese Aufgabe erfindungsgemäß durch ein Verfahren nach Anspruch 1 der eingangs genannten Art, bei dem das Abscheiden der Mischkristallschicht unter gleichzeitiger Anwendung i) des Kathodenzerstäubungsverfahrens duales Magnetronsputtern oder High Power Impulse Magnetronsputtern (HIPIMS) und ii) Lichtbogenverdampfen (Arc-PVD) durchgeführt wird.

Durch die erfindungsgemäße gleichzeitige Anwendung von dualem Magnetronsputtern oder HIPIMS und Lichtbogenverdampfen lassen sich mit Vorteil hochkristalline einphasige Mischkristallschichten herstellen, die im Wesentlichen frei sind von Makropartikeln (Droplets), zumindest aber eine deutlich geringere Anzahl von Makropartikeln aufweisen als nach bekannten Verfahren hergestellte Schichten. Es wird angenommen, dass sich die im Wesentlichen einphasige Mischkristallstruktur aufgrund der beim dualen Magnetronsputtern oder HIPIMS gegenüber einfachem Magnetronsputtern deutlich höheren Plasmaenergien ausbildet. Dies war überraschend. Gleichzeitig zeichnen sich die erfindungsgemäß hergestellten Schichten aufgrund Ihrer besonderen Gefügeeigenschaften durch vorteilhafte Härte und Wärmeleitfähigkeit aus.

Erfindungsgemäß besonders bevorzugte Mischkristallschichten sind Schichten von einphasigen Mischkristallen von Aluminium-Chrom-Oxid (AlCr)₂O₃. Schichten dieser Zusammensetzung können sowohl durch Lichtbogenverdampfen als auch durch einfaches oder duales Magnetronsputtern von beispielsweise einem AlCr(70/30) at%-Target abgeschieden werden. Bei der PVD-Abscheidung durch Lichtbogenverdampfen alleine erhält man zwar einen hohen Anteil der thermodynamischen stabilen Alpha-Phase des Mischkristalls, aber gleichzeitig auch einen sehr hohen Anteil an mit abgeschiedenen Makropartikeln (Droplets), welche die Qualität der Mischkristallschicht erheblich verschlechtern. Bei der Abscheidung durch Magnetronsputtern wird zwar die Anzahl der mit abgeschiedenen Makropartikel (Droplets) gegenüber dem Lichtbogenverdampfen vermindert, jedoch erhält man kaum thermodynamisch stabile Alpha-Phase des Mischkristalls. Es konnte nun überraschend gezeigt werden, dass man durch das erfindungsgemäße Verfahren, welches gleichzeitige Anwendung von dualem Magnetronsputtern oder HIPIMS und Lichtbogenverdampfen einsetzt, Mischkristallschichten abscheiden kann, bei denen man gleichzeitig hochkristalline Mischkristallschichten erhält, die nahezu frei von Makropartikeln (Droplets) sind und die einphasig sind oder zumindest einen sehr hohen Anteil einer gewünschten Phase, z. B. stabile Alpha-Phase im Falle von Aluminium-Chrom-Oxid, und allenfalls geringe Anteile weiterer Phasen, z. B. Gamma-Phase im Falle von Aluminium-Chrom-Oxid, besitzen. Die Anwendung von einfachem Magnetronsputtern und Lichtbogenverdampfen, wie sie auch im Stand der Technik beschrieben ist, führt nicht zu dem gewünschten Ergebnis.

Bei dem erfindungsgemäßen Verfahren werden wenigstens zwei verschiedene Targets eingesetzt, nämlich ein Target mit wenigstens Chrom als Kathode im Lichtbogenverfahren und ein weiteres Target mit wenigstens Aluminium für die Kathodenzerstäubung im dualen Magnetronverfahren oder HIPIMS.

Als Targets können die reinen Metalle eingesetzt werden, beispielsweise reine Aluminium-Targets oder Chrom-Targets, oder gemischt metallische Targets, wie beispielsweise Aluminium/Chrom(70/30) at%-Targets. Zweckmäßigerweise setzt man das höher schmelzende Targetmaterial im Lichtbogenverfahren und das niedriger schmelzende Targetmaterial im dualen Magnetronverfahren oder HIPIMS ein. Ein erfindungsgemäß vorteilhaftes Beispiel ist die Verwendung eines metallischen Chrom-Targets im Lichtbogenverfahren und eines metallischen Aluminium-Targets im dualen Magnetronverfahren oder HIPIMS. Setzt man die vorgenannten Targets umgekehrt ein, erhält man eine höhere Abscheidung von Makropartikeln (Droplets) und einen geringeren Grad an Kristallinität der Mischkristallschichten.

Für das erfindungsgemäße Verfahren eignen sich duales Magnetronsputtern und High Power Impulse Magnetronsputtern (HIPIMS). Ganz besonders bevorzugt ist reaktives duales Magnetronsputtern, beispielsweise unter Verwendung rein metallischer Targets und Sauerstoff als Reaktivgas.

In einer weiteren Ausführungsform der Offenbarung wird für die Anwendung des dualen Magnetronverfahrens oder HIPIMS wenigstens ein Target verwendet, welches wenigstens das erste Metall (M1) enthält. Alternativ können für die Anwendung des dualen Magnetronverfahrens oder HIPIMS aber auch gemischt metallische Targets verwendet werden, die sowohl das erste Metall (M1) als auch das zweite Metall (M2) und gegebenenfalls weitere Metalle enthalten. Ein Beispiel für ein gemischt metallisches Target in dem bereits genannten Aluminium-Chrom-Oxid-System wäre ein Aluminium/Chrom(70/30) at%-Target.

Für die Anwendung des Lichtbogenverdampfens (Arc-PVD) wird wenigstens ein Target verwendet, welches wenigstens das zweite Metall (M2) enthält.

Wenn im Zusammenhang mit dieser Anmeldung angegeben ist, dass ein Target ein Metall oder mehrere Metalle enthält, so umfasst dies sowohl rein metallische Targets als auch keramische Targets, in denen das Metall oder die Metalle als Oxid vorliegt bzw. vorliegen.

Erfindungsgemäß sind das erste Metall und das zweite Metall Aluminium und Chrom. Eine Aluminium-Chrom-Mischoxidschicht innerhalb einer Werkzeugbeschichtung hat sich als besonders vorteilhaft erwiesen. Diese Beschichtungen weisen eine sehr hohe Härte und Verschleißbeständigkeit auf.

In einer bevorzugten Ausführungsform der Erfindung werden für die Herstellung von Aluminium-Chrom-Mischoxidschichten für die Anwendung des dualen Magnetronverfahrens oder HIPIMS zwei Aluminium-Targets oder ein Aluminium-Target und ein gemischtes Aluminium-Chrom-Target verwendet. Für das Lichtbogenverdampfen (Arc-PVD) werden ein oder zwei Chrom-Targets verwendet. Innerhalb der PVD-Vorrichtung sind für das gleiche PVD-Verfahren vorgesehenen Targets auf einander gegenüberliegenden Seiten der Substrathalter angeordnet.

In einer weiteren Ausführungsform der vorliegenden Erfindung werden die Mischkristallschichten in Schichtdicken von 0,2 nm bis 10 µm, vorzugsweise von 5 nm bis 1 µm, besonders bevorzugt 10 nm bis 100 nm abgeschieden. Zu große Schichtdicken haben den Nachteil, dass die Lagen aufgrund ungünstiger Spannungszustände abplatzen können. Zudem nimmt die Abscheidungsgeschwindigkeit mit zunehmender Schichtdicke ab, so dass die Abscheidung aufgrund sehr geringer Abscheidungsgeschwindigkeit unwirtschaftlich werden kann.

Die Mischkristalloxidschichten der vorliegenden Erfindung können in sich eine Lagenstruktur aufweisen, die aufgrund der Rotation der Substrate bei der Abscheidung in der PVD-Apparatur in Abhängigkeit von der Rotationsgeschwindigkeit entstehen kann. Die übereinander angeordneten Lagen können dabei gemäß der Target-Zusammensetzung unterschiedliche Chemische Zusammensetzung und/oder unterschiedliche Orientierungen der Kristalle aufweisen, wobei das Kristallsystem der übereinander angeordneten Lagen innerhalb einer Mischkristalloxidschicht das gleiche ist. Die Dicke der einzelnen Lagen innerhalb einer Mischkristalloxidschicht kann von 0,1 nm bis 1 µm, vorzugsweise 2 nm bis 500 nm, besonders bevorzugt 3 nm bis 50 nm, ganz besonders bevorzugt 5 nm bis 15 nm betragen.

In einer weiteren Ausführungsform des erfindungsgemäßen Verfahrens ist das Substrat für die Abscheidung der Mischkristallschichten aus Hartmetall, Cermet, Stahl oder Schnellarbeitsstahl (HSS) hergestellt. Besonders bevorzugt ist das Substrat aus Hartmetall oder Cermet hergestellt.

In einer weiteren Ausführungsform des erfindungsgemäßen Verfahrens wird für das Lichtbogenverdampfen (Arc-PVD) Targetmaterial mit einem Schmelzpunkt über 700 °C, vorzugsweise über 1000 °C, besonders bevorzugt über 1500 °C verwendet. Die Verwendung eines Targetmaterials mit einem hohen Schmelzpunkt im Lichtbogenverfahren hat den Vorteil, dass gegenüber einem niedrig schmelzenden Targetmaterial erheblich weniger Makropartikel (Droplets) mit abgeschieden werden.

Bevorzugt ist die wenigstens eine Mischkristallschicht der mehrlagigen Beschichtung eine Aluminium-Chrom-Oxid-Mischkristallschicht, welche vollständig oder wenigstens 90 Vol.-% davon in der Alpha-Phase vorliegt.

Die erfindungsgemäße Mischkristallschicht hat den Vorteil, dass sie ein besonders hohes Maß an Kristallinität und einen geringen Anteil an abgeschiedenen Makropartikeln (Droplets) aufweist. Im System der Aluminium-Chrom-Mischoxide und in vergleichbaren Sytemen mit ähnlicher Kristallstruktur erhält man unter Anwendung des erfindungsgemäßen Verfahrens ein besonders hohen Anteil der thermodynamisch stabilen Alpha-Phase des Mischkristalls. Die Vorteile sind hohe Härte, hohe Verschleißbeständigkeit, hohe Temperaturbeständigkeit, hohe Temperaturwechselbeständigkeit,

### Beispiele

In einer PVD-Apparatur wurden Hartmetallsubstrate gemäß der vorliegenden Erfindung (Beispiele 1 und 2) sowie konventionell (Vergleichsbeispiele 1 und 2) mittels dualem Magnetronsputtern alleine (Vergleichsbeispiele) oder in Kombination mit Lichtbogenverdampfung (erfindungsgemäße Beispiele) mit Aluminium-Chrom-Mischoxidschichten bzw. Aluminiumoxid beschichtet. Anschließend wurden die Vickers-Härte (HV) und das reduzierte E-Modul (EIT/(1-v²)) bestimmt. Die Versuchsparameter und Ergebnisse sind in den nachfolgenden Tabellen wiedergegeben.

Durch Röntgenbeugungsuntersuchungen wurde bestätigt, dass die Schichten der Beispiele 1 und 2 einphasige Mischkristallschichten aus Alpha-Aluminium-Chrom-Oxid waren, wogegen Vergleichsbeispiel 1 nur ein Gemisch aus Gamma-Aluminiumoxid und amorphem Aluminiumoxid und Vergleichsbeispiel 2 eine Mischung aus Alpha- und Gamma-Phasen lieferten. Alle Schichten waren im Wesentlichen frei von Makropartikeln (Droplets).

| **Prozessparameter** | **Beispiel 1** | **Beispiel 2** | **Vergleichs- beispiel 1** | **Vergleichs- beispiel 2** |
|---|---|---|---|---|
| duales Magnetron | Al-Rechtecktargets (81cm x 16cm) | Al- und AlCr(70/30) at%-Rechtecktargets (81cm x 16cm) | Al-Rechtecktargets (81cm x 16cm) | AlCr(70/30) at%-Rechtecktargets (81cm x 16cm) |
| Lichtbogenverdampfung | 4 Cr-Rundquellen (Ø 63mm) mit je 75A | 4 Cr-Rundquellen (Ø 63mm) mit je 75A | | |
| Substratvorspannung | 120V (unipolar gepulst Frequenz 100Hz) | 60V (unipolar gepulst Frequenz 100Hz) | 150V | 150V |
| Leistung (duales Magnetron) | 20kW | 20kW | 20kW | 20kW |
| Argonfluss | 180sccm | 180sccm | 500sccm | 500sccm |
| Sauerstofffluss | 500sccm | 500sccm | 100sccm | 100sccm |

| | **Beispiel 1** | **Beispiel 2** | **Vergleichs- beispiel 1** | **Vergleichs- beispiel 2** |
|---|---|---|---|---|
| Vickers-Härte (HV) | 2438 | 2270 | 2101 | 2602 |
| EIT/(1-v²) | 328 GPa | 280 GPa | 315 GPa | 339 GPa |

## Patentansprüche

1. Verfahren zum Abscheiden von einphasigen Mischkristallschichten aus Aluminium-Chrom-Oxid auf einem Substrat mittels PVD-Verfahren, **dadurch gekennzeichnet, dass** das Abscheiden der Mischkristallschicht unter gleichzeitiger Anwendung i) des Kathodenzerstäubungsverfahrens duales Magnetronsputtern oder High Power Impulse Magnetronsputtern (HIPIMS) und ii) Lichtbogenverdampfen (Arc-PVD) durchgeführt wird, wobei für die Anwendung des Kathodenzerstäubungsverfahrens duales Magnetronsputtern oder High Power Impulse Magnetronsputtern (HIPIMS) wenigstens ein Target verwendet wird, welches wenigstens Aluminium und gegebenenfalls zusätzlich Chrom enthält, und für die Anwendung des Lichtbogenverdampfens (Arc-PVD) wenigstens ein Target verwendet wird, welches wenigstens Chrom enthält.

2. Verfahren nach Anspruch 1, **dadurch gekennzeichnet, dass** für die Anwendung des Kathodenzerstäubungsverfahrens duales Magnetronsputtern oder High Power Impulse Magnetronsputtern (HIPIMS) mit zwei Aluminium-Targets oder einem Aluminium-Target und einem gemischten Aluminium-Chrom-Target verwendet wird und für das Lichtbogenverdampfen (Arc-PVD) wenigstens ein Chrom-Target verwendet wird.

3. Verfahren nach einem der vorangegangenen Ansprüche, **dadurch gekennzeichnet, dass** das die Mischkristallschichten in Schichtdicken von 0,2 nm bis 10 µm, vorzugsweise von 5 nm bis 1 µm, besonders bevorzugt von 10 nm bis 100 nm abgeschieden werden.

4. Verfahren nach einem der vorangegangenen Ansprüche, **dadurch gekennzeichnet, dass** das Substrat aus Hartmetall, Cermet, Stahl oder Schnellarbeitsstahl (HSS) hergestellt ist.

5. Verfahren nach einem der vorangegangenen Ansprüche, **dadurch gekennzeichnet, dass** für das Lichtbogenverdampfen (Arc-PVD) Targetmaterial mit einem Schmelzpunkt über 700 °C, vorzugsweise über 1000 °C, besonders bevorzugt über 1500 °C verwendet wird.

## Claims

1. A method for depositing single-phase mixed crystal layers of aluminium-chromium-oxide on a substrate by means of PVD methods, **characterized in that** deposition of the mixed crystal layer is effected with simultaneous application of i) the cathode sputtering method of dual magnetron sputtering or high power impulse magnetron sputtering (HIPIMS) and ii) arc vapour deposition (Arc-PVD), wherein at least one target is used for application of the cathode sputtering method of dual magnetron sputtering or high power impulse magnetron sputtering (HIPIMS), which target contains at least aluminium and optionally additionally chromium, and at least one target which contains at least chromium is used for application of the arc vapour deposition method (Arc-PVD).

2. A method according to claim 1, **characterized in that** two aluminium targets or an aluminium target and a mixed aluminium chromium target is used for application of the cathode sputtering method of dual magnetron sputtering or high power impulse magnetron sputtering (HIPIMS), and at least one chromium target is used for the arc vapour deposition method (Arc-PVD).

3. A method according to one of the preceding claims, **characterized in that** the mixed crystal layers are deposited in layer thicknesses of 0.2 nm to 10 µm, preferably of 5 nm to 1 µm, particularly preferably of 10 nm to 100 nm.

4. A method according to one of the preceding claims, **characterized in that** the substrate is made from hard metal, cermet, steel or high speed steel (HSS).

5. A method according to one of the preceding claims, **characterized in that** target material with a melting point above 700 °C, preferably above 1000 °C, particularly preferably above 1500 °C, is used for the arc vapour deposition method (Arc-PVD).

## Revendications

1. Procédé pour déposer sur un substrat, selon un procédé PVD, des couches de cristal mixte à phase unique en oxide d'aluminium-chrome, **caractérisé en ce que** le dépôt de la couche de cristal mixte est effectué en mettant en oeuvre de manière simultanée i) le procédé de pulvérisation cathodique de pulvérisation double au magnétron ou de pulvérisation au magnétron à impulsions à haute puissance (HIPIMS) et ii) la vaporisation par arc électrique (Arc-PVD), où une cible est utilisée pour la mise en oeuvre du procédé de pulvérisation cathodique de pulvérisation double au magnétron ou de pulvérisation au magnétron à impulsions à haute puissance (HIPIMS), qui contient au mois de l'aluminium et, le cas échéant, du chrome, et où une cible est utilisée pour la mise en oeuvre de la vaporisation par arc électrique (Arc-PVD), qui contient au moins du chrome.

2. Procédé selon la revendication 1, **caractérisé en ce que** sont utilisées pour la mise en oeuvre du procédé de pulvérisation cathodique de pulvérisation double au magnétron ou de pulvérisation au magnétron à impulsions à haute puissance (HIPIMS), deux cibles d'aluminium ou une cible d'aluminium et une cible mixte aluminium-chrome, et qu'il est utilisée pour la vaporisation par arc électrique (Arc-PVD), une cible de chrome.

3. Procédé selon l'une des revendications précédentes, **caractérisé en ce que** les couches de cristal mixte sont déposées avec des épaisseurs de couche de 0,2 nm à 10 µm, de préférence de 5 nm à 1 µm et de manière particulièrement préférée de 10 nm à 100 nm.

4. Procédé selon l'une des revendications précédentes, **caractérisé en ce que** le substrat est fabriqué en métal dur, en cermet, en acier ou en acier à coupe rapide (HSS).

5. Procédé selon l'une des revendications précédentes, **caractérisé en ce qu'**il est utilisé pour la vaporisation par arc électrique (Arc-PVD), du matériau de cible ayant une température de fusion supérieure à 700 °C, de préférence supérieure à 1000 °C et de manière particulièrement préférée supérieure à 1500 °C.
